# EUROPEAN PATENT APPLICATION

(11) **EP 0 750 267 A1**
(43) Date of publication of application: **27.12.1996**
(21) Application number: 95304242.1
(22) Date of filing: 19.06.1995
(51) Int. Cl.: G06F 17/50, G06F 17/30

(54) **CAD system, CAD management apparatus, and method of processing CAD data**

(71) Applicant: MELCO INC., Nagoya-shi, Aichi-ken 460 (JP)
(72) Inventor: Tsuzuki, Chikai, c/o Melco Inc., Nagoya-shi, Aichi-ken 460 (JP)
(74) Representative: Price, Anthony Stuart

(57) **Abstract**

A CAD system (20) for realizing a desired design on a computer, wherein identical design information can be edited simultaneously by a plurality of CAD terminals (401-403) set in a GUI-based environment. The CAD terminals (401-403), executing a design command creating program, display transmitted design information on respective CRT displays (40D) to prepare for input of design data in the GUI-based environment. Each CAD terminal (401-403) creates a design command, which can be processed by a CAD management apparatus (30), based on a series of design data input through operations of a keyboard (40F) and a mouse (40H). The CAD management apparatus (30), executing a design information management program, processes design commands input from the CAD terminals (401-403) to update design information, and transmits the updated design information to any of the CAD terminals (401-403) which display a specific design area corresponding to the updated part of design information on the CRT display (40D). The corresponding CAD terminal (401-403) displays the updated design information on the CRT display 40D.

## Description

The present invention relates to a CAD (computer-aided design) system for decoding and executing input design commands to successively update design information and realize a desired design on a computer.

CAD systems for updating design information through manual input of commands from a keyboard on a terminal have been replaced by those for directly displaying shapes of design objects for input of design commands. These new CAD systems have a CRT graphic display for displaying shapes of design objects. The designer can input a desired design command by directly pointing a specified point in the displayed shape with a pointing device such as a graphics tablet or a mouse. In design of artwork on a printed circuit board, the designer successively specifies a desired land having coordinates (X1,Y1) and another land having coordinates (X2,Y2) on the screen with the pointing device to input a design command which instructs connection of a pattern between both the lands. Design information stored in a memory is updated through execution of the input design command.

Such a CAD system with a graphic display creates a wiring pattern from a point A to another point B and draws the created wiring pattern by simply requiring the designer to (1) select a command for creating a wiring pattern, (2) specify the point A from which a line starts, (3) specify the point B at which the line terminates, and (4) instruct execution of the command. The designer can operate such a CAD system without studying the complicated design commands and complete a desired design in an intuitively understandable GUI (graphical user interface) -based environment as if directly creating design drawings.

Design information applied in the CAD system is digital data which can be stored in an external storage device like a magnetic disk. In the environment with a plurality of CAD systems, the designer can edit design information to complete a design from any CAD system by reading design information stored in the storage device.

The conventional CAD system, however, only allows design information to be processed as electronic data and has the following problem. In a LAN (local area network) where a plurality of CAD systems and other peripheral equipment like an expensive mass storage magnetic disk are connected with one another to allow desired design information to be read from the plurality of CAD systems, the conventional structure allows identical design information to be edited by only one CAD. This means that a plurality of designers can not simultaneously edit the identical design information.

In the conventional CAD system, a CAD management apparatus can accept only one terminal, which allows the designer to input a desired design command by specifying arbitrary positions on the screen with a pointing device such as a graphics tablet. Simple connection of plural terminals with one CAD management apparatus results in malfunction or abnormal operations. For example, while one designer inputs drawing of a line from a point A to a point B from one terminal, when another designer specifies still another point C different from either the point A or B from another terminal, the commands from the different terminals may compete with each other. Such operations prevent the CAD management apparatus from recognizing both the design commands normally.

In actual design field with a CAD system, a plurality of designers are engaged in completion of complicated design information. In many cases, there are a plurality of designers (that is, a plurality of clients for the CAD management apparatus) who desire to edit identical design information simultaneously. In design of a printed circuit board having complicated functions mounted thereon, for example, several designers are generally involved for different functional blocks, like a power source system, a signal processing system, and an input/output interface system. Otherwise, the time period required for design and development undesirably lengthens. It is also difficult to force only one designer to study design know-how in various fields.

In a workshop with a conventional single user supporting-CAD system, a plurality of designers are engaged in editing of design information according to a pre-arranged schedule. One method of solving the above problem of the conventional CAD system is to divide a design of one electrical appliance into plural functional blocks like a power source system and a signal processing system and complete design information of the respective functional blocks with a plurality of CAD systems. After completion of design for each block, designs of the respective blocks are joined with one another. This method, however, undesirably restricts the degree of freedom in the design procedure. For example, designers of the respective functional blocks are required to clearly specify the rules for interface signals between blocks and wiring areas. In the case that some designers can not follow the rules, a meeting is required for further modifications or changes.

The object of the invention is thus to provide a CAD system, a CAD management apparatus, and a method of processing CAD data, which allow a plurality of designers to edit identical design information simultaneously while maintaining a GUI-based environment.

The CAD system, the CAD management apparatus, or the CAD data processing method according to the invention provides designers with a plurality of GUI-based environments for the design purpose. The structure of the invention allows the designer to successively input design data in the GUI-based environment. The CAD management apparatus manages a plurality of design commands in time series, updates adjustable design information, and instructs a display based on the updated design information according to the requirements.

An embodiment of the present invention will now be described, by way of example only, with reference to the accompanying drawings, in which:
Fig. 1 is a block diagram illustrating a general structure of a CAD system embodying the invention;
Fig. 2 is a flowchart showing a design command creating program and a design information management program executed in the CAD system;
Fig. 3 shows a relationship between displays on CAD terminals and design information; and
Fig. 4 shows a process of creating design commands in each CAD terminal.

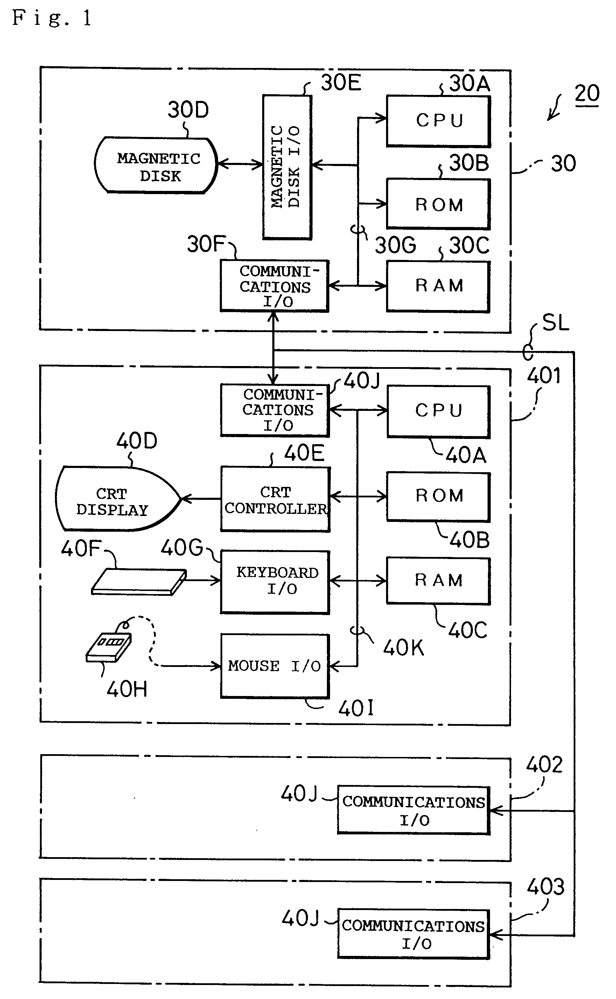

Referring to Fig. 1, a CAD system 20 of the embodiment includes a CAD management apparatus 30 and a plurality of CAD terminals 401,402,403..., which are connected with one another via a communications line SL. The CAD management apparatus 30 as well as each CAD terminal 401 (402,403) is constructed as an intelligent device with a computer.

The CAD management apparatus 30 is a server including a high-speed CPU 30A with an RISC (reduced instruction set computer) architecture, mass storage ROM 30B and RAM 30C, and a mass storage magnetic disk 30D. The CAD management apparatus 30 is further provided with a magnetic disk input/output interface 30E (hereinafter referred to as I/O) allowing information to be input into and output from the magnetic disk 30D and a communications I/O 30F connecting with the communications line SL. These components in the CAD management apparatus 30 are connected with one another via an internal bus 30G.

A plurality of large-volume design information corresponding to a plurality of design drawings are stored in the magnetic disk 30D and centrally managed by the CPU 30A. A specific storage area to allow a large volume of design information to be extended sufficiently is set in a main memory of the RAM 30C. Design information which can not be extended physically in the specific storage area is extended in a virtual storage area set in the magnetic disk 30D by means of virtual storage function of the CPU 30A.

An operating system (OS) and a variety of design conditions which design information must follow are stored as non-volatile storage in the ROM 30B. The operating system is applied to integrally control the respective components of the CAD management apparatus 30 and manage design commands input from the CAD terminals 401 through 403.

Design information centrally managed by the CAD management apparatus 30 may be processed discretely by the plurality of CAD terminals 401 through 403. The plurality of CAD terminals 401 through 403 have an identical structure, which includes a CPU 40A for allowing design data to be input in a GUI (graphical user interface) -based environment, a ROM 40B for non-volatile storage of required programs and other data, and a RAM 40C working as a main storage. Each CAD terminal 401 (402, 403) is further provided with a CRT 40D for displaying graphics, a CRT controller 40E for controlling the CRT 40D, a keyboard 40F used to enter character data, a keyboard I/O 40G, a mouse 40H working as a pointing device for pointing an arbitrary position on the CRT 40D, and a mouse I/O 40I. Each CAD terminal 401 (402,403) also includes a communications I/O 40J connecting with the communications line SL for allowing information to be transferred from and to the CAD management apparatus 30. The communications I/O 40J and the other components of each CAD terminal 401 (402,403) are connected with one another via an internal bus 40K.

General graphics display programs and graphics input programs for realizing a GUI-based environment are previously stored in the ROM 40B of each CAD terminal 401 (402,403) and read and processed according to the requirements from the CPU 40A.

The respective communications I/Os 30F and 40J of the CAD management apparatus 30 and the CAD terminals 401 through 403 satisfy an identical physical and logical communications standard such as Ethernet or Token Bus to allow transmission and exchange of information via the communications line SL.

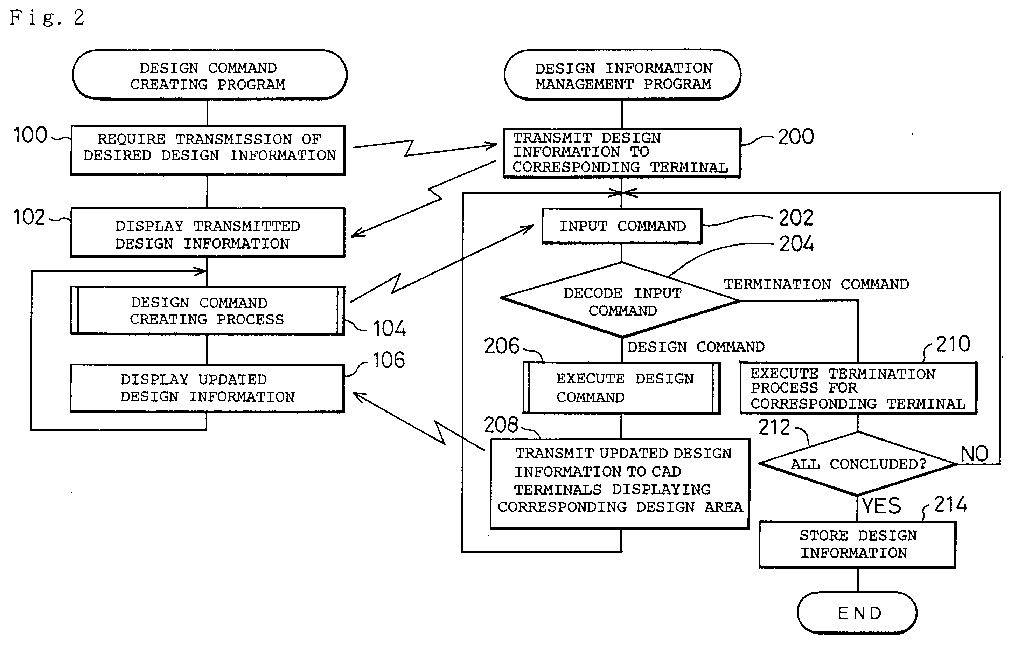

A design information management program and a design command creating program executed by the CAD management apparatus 30 and the CAD terminals 401 through 403 in the CAD system 20 are described with referring to Figs. 2 through 4.

As shown in Fig. 2, in the design command creating program executed by the CAD terminals 401 through 403, the CPU 40A of the CAD terminal 401 (402,403) initially requires the CAD management apparatus 30 to extend in its RAM 30C desired design information stored in its magnetic disk 30D and transmit partial data of design information to be updated, according to instructions input from the keyboard 40F or the mouse 40H (step 100). The CAD terminal 401 (402,403) transmits additional information required for communications with the CAD management apparatus 30, which includes ID data individually allocated with design information to each CAD terminal 401 (402,403) and a display capacity of the CRT display 40D (for example, inches or a number of pixels to allow display).

The CAD management apparatus 30 receives the requirement from the CAD terminal 401 (402,403), and refers to the ID data of the CAD terminal 401 (402,403) to transmit the required data of design information to the CAD terminal 401 (402,403) according to the display capacity of its CRT display 40D (step 200). The CAD management apparatus 30 then waits for another input from the CAD terminals 401 through 403.

The CAD terminal 401 (402,403) displays the design information transmitted from the CAD management apparatus 30 graphically on its CRT display 40D to prepare for input of design data in the GUI-based environment (step 102). Until an input of specific operations for terminating the design procedure, design command creating process for receiving inputs of design data (step 104) and display of updated design information (step 106) are repeatedly executed.

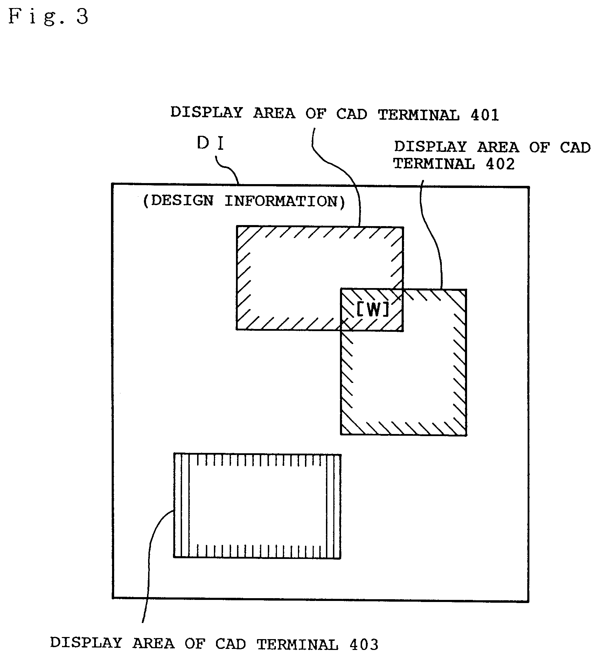

The foregoing process allows partial designs corresponding to desired data of large-volume design information to be displayed graphically on the CRT displays 40D of the respective CAD terminals 401 through 403 as shown in Fig. 3. A designer can execute the subsequent design data input process in the GUI-based environment while referring to the graphical display of designs. Fig. 3 illustrates an image of arbitrary design information DI, where specific parts of a design corresponding to the design information DI are displayed on the CRT displays 40D of the respective CAD terminals 401 through 403. In the example of Fig. 3, all the CAD terminals 401 through 403 require transmission of partial data of the identical design information DI, and displays of the design information DI on the CRT displays 40D of the CAD terminals 401 and 402 partially overlap with each other. The design information DI displayed on the CRT display 40D of each CAD terminal 401 (402,403) is up-to-date, and identical partial designs are thus assigned to a specific part W of the design information DI which is displayed overlappingly on the CAD terminals 401 and 402 (hereinafter referred to as the partial overlapping area).

While referring to the screen on the CRT display 40D, the designer successively inputs design data through operations of the keyboard 40F or the mouse 40H. In the design command creating process executed at step 104 in the flowchart of Fig. 2, each CAD terminal 401 (402,403) creates a design command corresponding to the input design data and transmits the design command to the CAD management apparatus 30 via the communications I/O 40J.

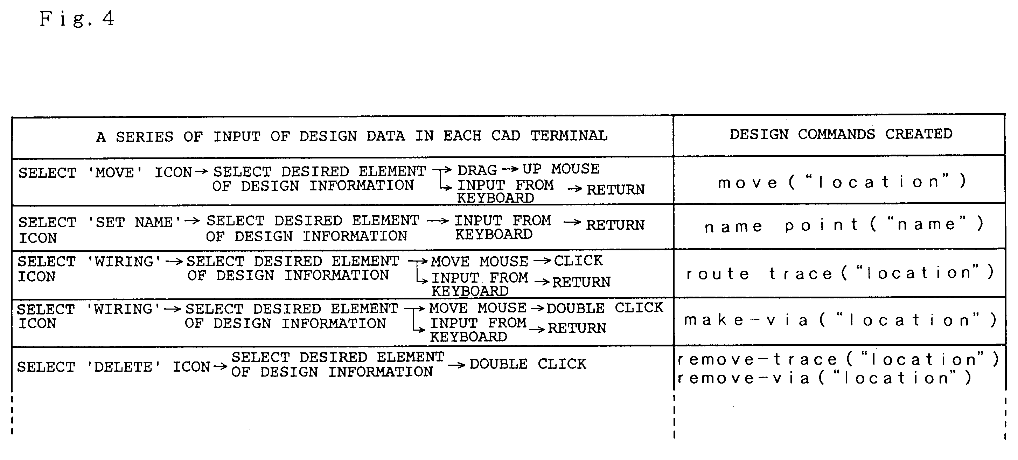

Fig. 4 shows a process of creating design commands. Design commands are instructions or words in a predetermined command system understood and processed by the CAD management apparatus 30. The CAD management apparatus 30 edits design information extended in the RAM 30C and executes actual design procedure, based on these design commands. In the conventional system which requires direct input of such design commands from the CAD terminals 401 through 403, the designer is forced to memorize all the design commands. Such structure does not ensure a preferable design environment. In the CAD system 20 of the embodiment, on the other hand, the CAD terminals 401 through 403 realize the GUI-based environment and create design commands, which the designer requires, corresponding to a series of inputs of design data. The series of inputs of design data include selection of a command icon (by clicking a desired icon with the mouse 40H), selection of a desired element of design information for which the command is executed (by clicking with the mouse 40H or inputting an element name from the keyboard 40F), and input of numerals required for execution of the command (by dragging with the mouse 40H or inputting an absolute or relative value from the keyboard 40F). The CAD terminals 401 through 403 subsequently transmit the design commands thus created to the CAD management apparatus 30. An identification code for identifying each CAD terminal is preferably attached to each design command.

The CAD management apparatus 30 receives each design command thus created and adds the received design command to the end of a waiting list arranged in the order of input (step 202). The CAD management apparatus 30 successively reads the design commands from the waiting list and decodes each design command according to the predetermined command system (step 204). When it is determined that the design command follows a predetermined design command system at step 204, the program proceeds to step 206 at which the CAD management apparatus 30 executes the design command and edits a required part of design information extended in the RAM 30C. The CAD management apparatus 30 then transmits the results of editing as updated design information to all the CAD terminals 401 through 403, which display on the CRT 40D the required part of design information updated through execution of the design command. The program then returns to the command input process executed at step 202.

When it is determined that the design command input from the CAD terminal 401 (402,403) requires termination of design procedure at step 204, the program proceeds to step 210 at which the CAD management apparatus 30 transmits a termination signal for allowing the corresponding CAD terminal 401 (402,403) to cut off the communications. The program then goes to step 212 at which it is determined whether the design information, for which termination of the design procedure is required, is not applied in any of the CAD terminals 401 through 403. When it is determined that none of the CAD terminals 401 through 403 requires the design information extended in the RAM 30C at step 212, the program proceeds to step 214 for non-volatile storage of the design information in the magnetic disk 30D, and goes to END. Otherwise, the program returns to the command input process executed at step 202. The design information extended on the main memory of the RAM 30C is rewritten into the magnetic disk 30D according to a data storage command output from a CAD terminal, which is permitted to write data into the magnetic disk 30D. Re-writing of the design information into the magnetic disk 30D is not restricted at the time of termination of the design procedure, but the design information may be written as a temporary file onto the magnetic disk 30D at regular intervals. This structure preferably protects the data extended on the main memory.

The design information edited and processed by the CAD management apparatus 30 is transmitted to all the CAD terminals 401 through 403, which currently display on the CRT display 40D a specific part of design information updated through execution of the design command. This enables the designer to check the latest design information displayed on the CRT display 40D. When the CAD terminal 401 transmits a design command requiring an updating process with respect to the partial overlapping area W shown in Fig. 3, the design information DI updated through the execution of the design command is transmitted to not only the CAD terminal 401 but the CAD terminal 402 which also displays the partial overlapping area W of design information on its CRT display 40D.

The CAD system 20 of the embodiment thus constructed has the following advantages over the conventional system. The CAD terminals 401 through 403 ensure excellent operatability to execute the design procedure in the GUI-based environment. This allows the designer to accomplish the design through intuitively understandable operations as if directly creating design drawings, thereby improving the design efficiency and making the designer free from the troublesome process of memorizing complicated design commands.

The CAD management apparatus 30 and the CAD terminals 401 through 403 constitute a LAN (local area network). This allows the mass storage magnetic disk 30D to be used commonly by the plurality of CAD terminals.

The system of the embodiment also allows the respective CAD terminals 401 through 403 to simultaneously edit the identical design information in the presence of the partial overlapping area W. Even when the partial overlapping area W exists in the CAD terminals 401 through 403, design information is processed by the unit of design command. The latest design information is thus displayed on the respective CRT displays 40D, and simultaneous editing does not make the design information displayed on the CAD terminals 401 through 403 conflict with one another. This structure allows the highly integrated and complicated design information to be divided into several blocks for the design procedure, thereby improving the efficiency of design.

When a plurality of different design commands are input from the plurality of CAD terminals 401 through 403 almost simultaneously, execution of a prior design command may interfere with execution of a subsequent design command. The screen is updated at predetermined timings. Even when an object (such as land) is specified in the GUI-based environment for the subsequent design command, the specified object may have already been deleted by the prior design command. According to a favorable structure, an error message like 'Specified object does not exist.' or 'Specified command can not be executed by the process instructed from the terminal 401' is output to the corresponding CAD terminal. The latter message allows the designer to easily recognize the reason of error.

Some design commands input independently from the CAD terminal 401 are defined as a set of plural commands (command + object + required parameters), although each of such design commands can be specified by a single operation in the GUI-based environment. One example of these design commands is to move an object existing in a specified area. Execution of another design command input from another CAD terminal 402 or 403 during execution of such a design command defined as a set of plural commands may interfere with desired processing. A series of plural commands constituting one design command should be accordingly executed in an exclusive and successive manner.

According to one concrete application, an identification code is assigned to each of such design commands defined as a set of plural commands, and the CAD management apparatus 30 comprehensively executes the required processes for the design command. In another preferable structure, such a design command is input with first priority from the CAD terminal 401 (402, 403) to the CAD management apparatus 30.

In the embodiment, only parts related to the essential features of the invention are described for the clarity and simplicity of explanation. A variety of technologies applied to general CAD systems are also applicable to the CAD system of the invention as long as they are consistent with the features of the invention. For example, general CAD systems have a rule check function, which compares a requirement of updating design information based on a design command with a preset updating rule and sounds an alarm when the requirement of updating is inconsistent with the preset updating rule. In the structure of the above embodiment, such a rule check function may be added to the CAD terminals 401 through 403 or the CAD management apparatus 30. When the rule check function is applied to the CAD system, optimization according to the CAD system is required. For example, in one preferable structure, each CAD terminal executes rule checks proper to a design information block edited in the specific CAD terminal or those with little process loading, whereas the CAD management apparatus performs the other general and complicated rule checks.

As described previously, the CAD terminals 401 through 403 create design commands in the GUI-based environment, whereas the CAD management apparatus 30 decodes and executes the design commands. Communications between each CAD terminal 401 (402,403) and the CAD management apparatus 30 are realized by the standardized design commands. Accordingly it is not necessary that all the CAD terminals 401 through 403 create the design commands shown in Fig. 4 commonly. A CAD terminal set in any GUI-based environment, which is selected among a plurality of GUI-based environments fulfilling the designer's requirements, can be connected with the communications line SL of the above embodiment, as long as the CAD terminal eventually creates design commands required by the designer.

Although the CAD management apparatus 30 and all the CAD terminals 401 through 403 are constructed by separate computers in the above embodiment, the CAD management apparatus 30 and one of the CAD terminals 401 may be constituted by one computer.

The above embodiment is only illustrative and not restrictive in any sense. There may be many modifications, alterations, and changes without departing from the scope of essential characteristics of the invention. According to one modified structure, display information is transmitted to the CAD terminals 401 through 403 only according to requirements from the CAD terminals.

The scope of the present invention is limited only by the terms of the appended claims.

## Claims

1. A CAD system for receiving design commands and generating design information, said CAD system comprising a plurality of CAD terminals and a CAD management apparatus,
wherein each said CAD terminal comprises:
a display device for displaying information graphically;
display means for receiving display information from said CAD management apparatus and displaying a specific design shape corresponding to said display information on the display device;
input means for entering a parameter required for design, based on said specific design shape displayed on said display device;
design command creating means for creating a design command based on said input parameter according to a predetermined process; and
output means for outputting said design command to said CAD management apparatus,
said CAD management apparatus comprising:
command receiving means for receiving design commands created in said plurality of CAD terminals, in time series;
design information updating means for decoding and executing said design commands according to a preset rule, so as to update design information; and
display information transmitting means for transmitting display information based on said updated design information to said plurality of CAD terminals.

2. A CAD management apparatus comprising:
memory means for non-volatile storage of design information;
design command receiving means for receiving design commands independently output from a plurality of CAD terminals, in time series;
design command management means for managing said received design commands in a unit of minimum information required for execution of each said design command;
design command execution means for reading specific design information from said memory means to extend said specific design information in a predetermined area of a main memory, and successively decoding and executing said design commands based on a management by said design command management means, so as to update said specific design information extended in a predetermined area of said main memory; and
storage management means for updating design information stored in said memory means according to a specified instruction, based on said updated specific design information on said main memory.

3. A method of processing CAD data, said method successively decoding and executing design commands input from a plurality of CAD terminals having a display device and data input means to update design information and realizing a desired design on a computer, said method comprising the steps of:
receiving display information required for a display and displaying a design shape corresponding to said display information on said display device;
creating each said design command from design data input in a graphical user interface-based environment set in said display device according to a predetermined process and outputting each said design command;
receiving said output design commands and storing said design commands in time series;
decoding and executing each said design command according to a predetermined rule to update said design information; and
transmitting display information based on said updated design information to any of said plurality of CAD terminals which display a specific design area corresponding to said updated design information.
